# EUROPEAN PATENT SPECIFICATION

(11) **EP 0 546 011 B1**
(45) Date of publication and mention of the grant of the patent: **15.06.1994**
(21) Application number: 91915417.9
(22) Date of filing: 22.08.1991
(51) Int. Cl.: C23C 14/56, H01L 21/00

(54) **METHOD AND APPARATUS FOR REDUCING WAFER CONTAMINATION**
VERFAHREN UND VORRICHTUNG ZUM VERRINGERN DER WAFER-VERUNREINIGUNG
PROCEDE ET APPAREIL DE REDUCTION DE LA CONTAMINATION DE TRANCHES

(30) Priority: 28.08.1990 US 573845; 13.06.1991 US 714864
(43) Date of publication of application: 16.06.1993
(73) Proprietor: MATERIALS RESEARCH CORPORATION, Orangeburg New York 10962 (US)
(72) Inventor: HURWITT, Steven, D., Park Ridge, NJ 07656 (US)
(74) Representative: Findlay, Alice Rosemary
(86) International application number: PCT/US91/05999
(87) International publication number: WO 92/03590

(56) References cited:
- EP-A- 0 067 705
- EP-A- 0 136 562
- PATENT ABSTRACTS OF JAPAN, vol. 9, no. 237, 24.09.85
- PATENT ABTRACTS OF JAPAN, vol. 14, no. 427, 13.09.90

## Description

### Field of the Invention

The present invention relates to pressure sealed chambers and, more particularly, to the reduction of the contamination of objects in chambers of processing machines by particulates disturbed by the turbulent flow of gases during the evacuation or filling of a chamber or condensation caused by pressure reduction during the evacuation of moisture laden gas from a chamber.

### Background of the Invention

In the manufacture of semiconductor devices and other articles through coating or etching processes performed on wafers and other substrates, it is imperative that the contamination of the substrate surfaces to be processed be minimized. Surfaces to be protected from such contamination include, for example, the device surfaces of semiconductor wafers. The device surfaces are the surfaces of the wafers on which layers of conductive, insulative or other material are coated or etched by sputtering or other processes to form the manufactured devices. In such processes, the presence of microscopic contaminants on the device surface of a wafer may render an entire device functionally defective by adversely affecting the application or removal of a component layer at a critical point on the wafer surface.

Similarly, magnetic disks, optical disks, lenses, magneto-optical disks and other such objects may be substantially reduced in value or quality by contaminants present on the surface during processing. In the manufacture of large scale integrated circuits, a large quantity of semiconductor devices is formed of a single wafer. In the processing of such wafers, the contaminants present on the device surface of a wafer during processing can significantly reduce the number of such devices of acceptable quality produced from the wafer.

In a semiconductor processing apparatus such as a typical sputter coating or sputter etching machine, a wafer substrate is processed in an isolated and usually near vacuum environment. Such machines have a vacuum chamber in which the processing operations are carried out. The vacuum chamber is usually provided with one or more chamber doors located in the wall of the chamber through which wafers being processed are introduced and removed. On the outside of this chamber, the wafers are moved by some wafer handling mechanism between a cassette or carrier and the chamber door. A transfer mechanism, which is usually included in the external wafer handling mechanism, introduces the wafers into and removes them from the vacuum chamber through the chamber door opening. In the vacuum chamber, the wafer is usually received and held by a holder that supports the wafer during processing.

During the entry and removal of the wafers from the vacuum chamber, the portion of the chamber into which the wafers are placed and from which the wafer is removed will necessarily be at the same pressure and of the same atmospheric environment as exists in the external environment outside the chamber door. Such external environment will almost always contain air or some other gas containing some amount of water vapor. During processing, however, the portion of the chamber in which the wafer is to be processed must be brought to the vacuum pressure and atmospheric content as the process requires. This change of atmospheres necessitates a repetitive opening and isolation of the internal and external environments and the alternate pumping and venting of at least a portion of the vacuum chamber.

Wafer processing machines that process wafers in a vacuum environment most often maintain a constant vacuum environment so that processing upon some wafers can be carried out as others are being inserted into or removed from the chamber. To this end, such machines have an intermediate chamber or load lock at the entry to the processing chamber that alternately communicates with the external environment through the open chamber door, and, when the door is sealed, with the internal environment of the processing chamber through a sealable entry thereto. Such a load lock is alternately pumped to the vacuum level of the internal environment of the main processing chamber and vented to the external environment so that the pressure of the load lock matches that of environment with which it communicates during the introduction into and removal from the processing chamber of the wafers. With such a load lock, the internal portion of the chamber where processes are carried out may be maintained continuously at the pressure and composition of the vacuum environment and may be used additionally for the processing of other wafers while wafers are being introduced into and removed from the load lock chamber.

Some processing machines are provided with two load lock chambers, one for the introduction of unprocessed wafers into the main chamber and one for removal of processed wafers from the main chamber. To avoid delay of processing operations being carried out in a processing chamber while wafers are being exchanged through the load locks, each of the operations of pumping the chamber and venting the chamber must take place in one machine or processing cycle. Where a single load lock is provided, to avoid such delays both entry of wafers into and removal of wafers from the apparatus must occur sequentially in one such machine cycle. This cycle must encompass the venting of the chamber to the pressure of the external environment, the opening of the load lock chamber door, exchange of a processed wafer for an unprocessed wafer in the load lock, the closing of the chamber door, and a pumping of the load lock to the vacuum pressure level of the internal environment of the processing chamber.

Other types of processing machine, such as batch processing machines may have no load lock, but are instead opened to the external environment and loaded with the objects to be processed. In such machines, the entire processing chamber is repeatedly pumped and vented.

Often, the wafer processing involves a number of processing steps, each performed at a different processing station within a main chamber of a single wafer processing apparatus. In such an apparatus, different processes may be performed simultaneously at different processing stations differently on different wafers. The duration of these steps may be viewed as one machine cycle. At the beginning of each cycle, the load lock doors to the external environment are closed, the load lock chamber is pumped to the vacuum level of the processing chamber and the load lock or load locks are opened to the main chamber. An unprocessed wafer is supported in a holder in the load lock chamber while one or more wafers, once fully processed, is held in the main chamber at a final processing station. With the main chamber open to the load lock or load locks, one unprocessed wafer is moved into the main chamber from a load lock while one fully processed wafer is moved from the main chamber to the same or another load lock. At the end of each cycle, the load lock chamber is isolated from the main chamber, vented to the external environment and then opened to the external environment so that the processed wafer can be removed.

The operation of the load lock of a wafer processing machine having a single load lock proceeds in a cycle that begins with an opening of the load lock to the main chamber, the movement of a processed wafer from the main chamber to the load lock chamber where it replaces an unprocessed wafer which is simultaneously moved to the main chamber from the load lock chamber, and the sealing of the load lock to isolate the load lock chamber the internal processing environment of the main chamber so that processing in the main chamber can proceed. Once sealed, the load lock chamber is vented to the external atmosphere at a flow rate which allows for the opening of the load lock door, exchange of a processed wafer for an unprocessed wafer and the pumping of the load lock back to the vacuum pressure level during the machine process cycle. Both the pumping and the venting of the load lock cause a turbulent flow of gas within the load lock chamber.

In this and other types of processing machines, gases are pumped and vented into or out of processing and other chambers in which wafers or other substrates are being held before, during or after processing. Turbulent gas flow is often unavoidable in such chambers. In chambers such as processing and etching chambers, for example, a turbulent flow of gas during pumping or venting may occur. In these chambers, too, particulates are disturbed and may move to surfaces of objects which must be protected from such particulate contamination.

In the course of gas flow into and out of the load lock and other chambers, minute microscopic particulates, which have unavoidably collected on surfaces within the chamber, are disturbed by the turbulence of the flowing gas. The turbulently flowing gas picks up and carries the disturbed particulates about the chamber. In the prior art, many of these particulates come into contact with the device surface of the wafer within the chamber. This turbulent redistribution of particulates about the load lock chamber occurs when the vented gas is introduced into the chamber prior to the removal of a processed wafer from the chamber, and in addition, when gas is pumped from the chamber after an unprocessed wafer has been inserted into the chamber prior to the processing of the wafer.

The contact of particulates with the device surfaces of wafers results in adhesion of the particles which in turn causes the likely formation of defective devices as the particles interfere with the coating and etching processes and the deposition and removal of semiconductor layers on the wafer.

Heretofore in the prior art, the effort to minimize the particle contamination of the surfaces of wafers and other such substrates has generally focused on the meticulous and thorough cleaning of the chambers and on efforts to maintain an ultraclean environment surrounding the apparatus to thereby reduce the introduction of contaminating particulates into the chambers. Such efforts have resulted in expensive and time consuming solutions to the particulate contamination problem.

Furthermore, whenever a chamber is loaded and sealed, it is necessary to pump the chamber to a near vacuum level, and to maintain high productivity, the atmosphere should be pumped from the chamber as rapidly as possible. This pumping, when it is done rapidly, often causes moisture contained in the air within the chamber to momentarily condense, forming a temporary fog in the chamber. This condensate can precipitate onto the surface to be processed of the object within the chamber. This moisture, when it evaporates from the object surface, often leaves a microscopic residue. This residue can contaminate the surface to be processed, which can cause defective processing of the object to occur.

Accordingly, there is a need to reduce the particulate contamination of semiconductor wafer disks, and other objects in load locks and other pressure chambers of processing machines when turbulent gas is flowing therein and to render the cleaning of chambers and the maintenance of a clean environment in the vicinity of machines employing such chambers less expensive and less critical.

Accordingly, there is a further need to reduce the contamination, by condensation of water vapor, of semiconductor wafer disks, and other objects in load locks and other pressure chambers of processing machines when rapid pumping of the chamber containing the object to a near vacuum level is occurring.

Japanese Patent Application 60-96755 describes an apparatus for vapour depositing a substrate supported in a chamber. Covers are provided around the substrate with a first opening to allow the vapour deposition on one surface of the substrate and a second opening, opposite the surface for the supply of clean air at a pressure higher than that of the chamber.

It is an objective of the present invention to limit the contamination of the critical surfaces of wafers and other objects in load locks and other pressure chambers.

It is another objective of the present invention to provide a method for venting a chamber that avoids the transporting of particulates disturbed by turbulent gas flow in the lock chamber to the surface to be subjected to processing of the object supported therein. It is a further objective of the present invention to provide a method of reducing contamination of such object surfaces during the pumping of a load lock or other pressure chamber. It is a still further objective of the present invention to provide a chamber, particularly a load lock chamber, that protects the surfaces of objects to be processed from particulate contamination during the venting or pumping of the chamber.

It is a further objective of the present invention to prevent the contamination of the critical surfaces of wafers and other objects in load locks and other pressure chambers from vapor which condenses during the pumping of a load lock or other pressure chamber.

A method of protecting a substrate supported in a pressure sealed chamber of a processing apparatus from contamination borne by a gas during a change of gas pressure within the chamber, in accordance with the invention, comprises covering the substrate, the cover having an orifice therein, changing the pressure of the contaminant carrying gas within the chamber by flowing gas through a port in the wall of the chamber, and introducing a clean gas through the orifice during the changing of the gas pressure, characterised in that at least one particular surface of the substrate is protected, which surface is to be subjected to processing, in that a gap is formed covering the surface to be protected which is adjacent and parallel to the surface and has a boundary encircling the surface and the gap orifice and communicating with the chamber and in that the method includes guiding the introduced clean gas along the gap across the surface to be protected and outwardly from the gap along the boundary thereof and into the chamber during the changing of the pressure of the contaminant carrying gas within the chamber to limit the flow of gas borne contaminants from the chamber, into the gap and onto the surface to be protected.

A processing apparatus in which substrates are processed in an internal environment isolated from an external environment, in accordance with the invention, comprises a chamber sealable from the external environment and having a substrate holder for supporting a substrate in the chamber, a gas inlet port and a gas outlet port, one of the ports being a vent port for venting the chamber to the pressure of the external environment, and the other of the ports being a pump port for pumping the chamber to the pressure of the internal environment, means for changing the pressure within the chamber between that of the internal and that of the external environments, a cover for the substrate with an orifice therein and means for supplying a gas at the orifice that is relatively clean of contaminants from which the substrate is to be protected, characterised in that in use at least one particular surface of the substrate is protected from contamination, which surface is to be subjected to processing, and in that the apparatus includes a guide having the orifice therein and positioned to lie adjacent and parallel to and closely spaced from the surface to be protected to form a gap covering the surface to be protected with the periphery of the gap surrounding the orifice and the surface to be protected and means for introducing the clean gas from the gas supplying means into the gap through the orifice in the guide at a pressure that is sufficient to produce pressure around the periphery of the gap that exceeds the pressure of the chamber and decreases from the orifice to the periphery of the gap and is sufficient to maintain a flow of the clean gas outwardly from the gap at the periphery thereof and into the chamber when a substrate is supported in the chamber and pressure is changing therein, so as to thereby limit the flow of gas borne contamination from the chamber, into the gap and onto the surface to be protected.

Clean gas is introduced into the chamber, suitably during both the evacuation and the filling of the chamber, in such a way as to form a pressurised layer of the clean gas adjacent at least one surface to be protected of the substrate supported in the chamber. The pressurised layer of clean gas pneumatically shields the surface of the object from contamination borne by gas within the chamber.

Very preferably, the clean gas introduced is exceptionally dry, particularly during the evacuation of the chamber, so as to form a pressurized layer of the clean dry gas adjacent at least one surface to be protected of a object supported in the chamber. The pressurized layer of clean dry gas pneumatically shields the surface of the object from contamination by condensed moisture borne by the gas within the chamber should any vapor condense during the evacuation of the chamber.

According to a preferred embodiment a shield or guide plate is maintained in close spaced, generally parallel, relationship with the object surface to be protected, at for example the frontplane of a semiconductor wafer supported in the chamber. The plate covers the entire device surface of the wafer to be processed, and in combination with the wafer device surface forms the gap between the plate and the surface to be protected adjacent the surface. Through an orifice in this plate, the clean dry gas such as nitrogen or argon is introduced during the filling and evacuation of the chamber. The pressure of the gas at the orifice is such as to maintain a positive pressure, with respect to the chamber environment, at the periphery of the gap around the edge of the surface being protected so that the clean dry gas flows from the orifice radially outwardly through the gap periphery, thereby preventing, or at least inhibiting, particles that become borne by the flowing gas and moisture which condenses within the chamber during the rapid pumping of the chamber from entering the gap and precipitating onto the protected surface. Viewed differently, the outward flow of gas from the gap periphery deflects the flow of gas-borne particulates vapor, preventing the particles or moisture from entering the gap from the chamber and depositing onto the surface to be protected of the object in the chamber.

Preferably, the filling of the chamber is achieved, either entirely by the gas vented into the chamber through the orifice in the plate as described above, or with additional vent gas which enters the chamber through another port.

In accordance with a preferred embodiment of the invention, evacuation of a chamber is achieved by pumping gas from the chamber while simultaneously introducing clean dry gas through the plate and into the gap adjacent the surface to be protected of the object. The gas introduced during the evacuation of the chamber is introduced at a flow rate sufficient to pressurize the gap between the plate and the surface to be protected at a level greater than that in the chamber. The introduction of such vent gas during the chamber pumping process is at a rate which is nonetheless small with respect to the pumping flow rate.

It has been found that, in a wafer processing machine, with the load lock only pumped and vented in accordance with the present invention, the number of particulates added to a wafer is reduced from, for example, approximately 45 particles per wafer to approximately 10. Also, with the present invention, less stringent standards for the cleaning of the chamber and area around the chamber may be employed.

While the preferred embodiments of the invention are described herein for use with machines in which the processes are carried out in a vacuum or negative pressure environment, certain of the principles described herein are applicable to processes which occur at elevated pressures. The specific problems solved and advantages realized by the invention are particularly applicable to vacuum processes, however, especially for sputter processing operations. In addition, certain of the principles described herein are applicable whenever there is a rapid evacuation of the chamber and rapid pressure reduction, or where there is otherwise a tendency for moisture to condense within such a chamber. The specific problems solved and advantages realized by the invention are particularly applicable to vacuum processes, however, especially to sputter processing operations.

Furthermore, while the preferred embodiments of the invention are described in machines for coating or etching semiconductor wafers, the principles of the invention are applicable to machines and processes wherein other objects such as lenses, or magnetic, optical or magneto-optical disks are coated, etched or otherwise processed in chambers where turbulent gas flow or other particle dislodging may be present, or where moisture laden gas may be rapidly removed by pumping or venting of a chamber. With the present invention, various substrate surfaces, including but not limited to the device surfaces of semiconductor wafers, are protected from contamination by condensation. The protection is important in chambers such as load-lock chambers which are pumped and vented regularly causing pressure changes to occur which cause vapor to condense within the chamber. Other chambers such as reactive gas etching and sputter coating chambers are also pumped and vented, and will benefit from the present invention.

These and other objectives and advantages of the present invention will be more readily apparent from the following detailed description of the drawings in which:

### Brief Description of the Drawings

Fig. 1 is a diagram illustrating the venting of a load lock chamber or other such chamber of a vacuum processing apparatus, and showing the motion of turbulent gas and particulate contaminants borne by the gas within a load lock chamber constructed and operated according to the prior art.

Fig. 2 is a diagram similar to Fig. 1 illustrating the pumping of a load lock chamber or other such chamber of a vacuum processing apparatus, and the motion of turbulent gas and particulate contaminants borne by the gas, and the formation of gas borne condensation, within a chamber constructed and operated according to the prior art.

Fig. 3 is a diagram showing the venting of a chamber of a wafer processing apparatus constructed and operated in accordance with principles of the present invention.

Fig. 4 is a diagram showing the evacuation or pumping of a chamber of a wafer processing apparatus constructed and operated in accordance with principles of the present invention.

Fig. 5 is a cross-sectional view illustrating the load lock chamber represented in the diagrams of Figs. 3 and 4.

### Detailed Description of the Drawings

A load lock or other chamber operated according to one preferred embodiment of the present invention is particularly suitable for use in combination with a wafer processing apparatus such as the sputter coating and sputter etching apparatus disclosed in the commonly assigned U.S. Patents Nos. 4,909,695 and 4,915,564, both entitled "Method and Apparatus for Handling and Processing Wafer-Like Materials,".

These patents describe, in pertinent part, a method and apparatus for processing wafers, particularly for the sputter coating and etching of semiconductor wafers, in the vacuum environment maintained within a main chamber of the machine. In the apparatus described in the patents, wafers may be simultaneously and sequentially processed at a plurality of processing stations in the main vacuum processing chamber. In the main chamber, the wafers are held in a rotatable plate which indexes them in a circle among a plurality of angularly spaced stations, including a plurality of processing stations and a single load lock station at which is situated a load lock through which wafers are transported into and out of the main processing chamber and to and from an external environment. The load lock is sealable both from the main chamber and the external environment of the machine.

These above mentioned patents also disclose a mechanism for transporting unprocessed semiconductor wafers from the external environment and into a holder within the load lock, and removing processed wafers from the load lock to the external environment. These patents explain in detail the operation of the wafer handling mechanism, the structure and operation of the load lock, the structure and operation of the mechanism for moving a wafer supported in a holder between the load lock and stations within the main processing chamber, and the structure for isolating the load lock from the main processing chamber.

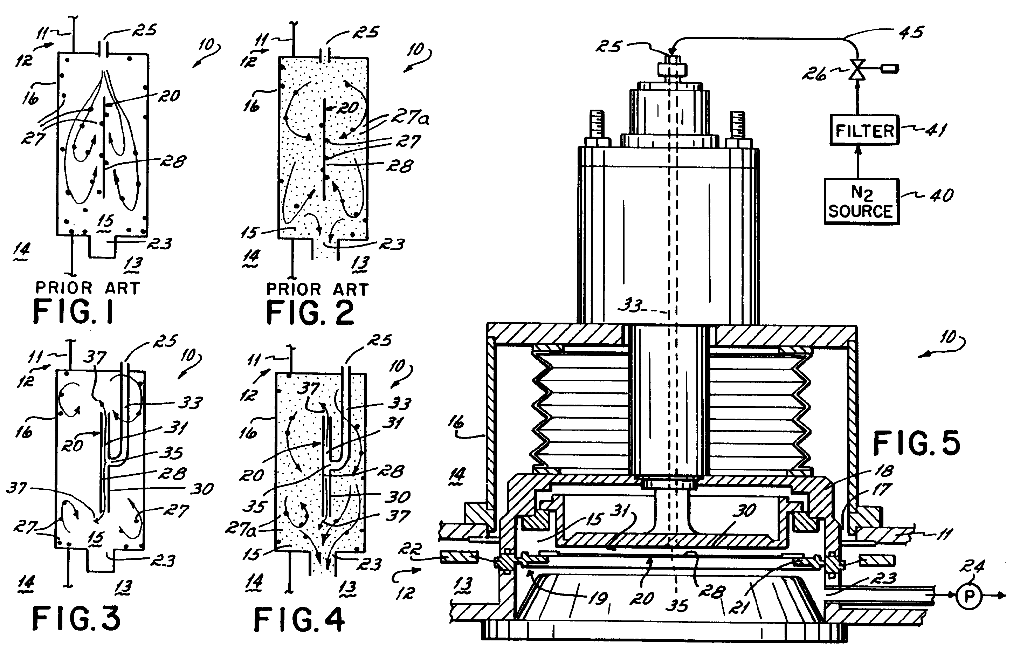

Figs. 1 and 2 represent devices of the prior art and other devices which are constructed without the features of the present invention. Figs. 3 and 4 represent a load lock incorporating the features of the present invention. Fig. 5 illustrates a load lock having the features of the load lock of Figs. 1 and 2, and, in addition, has the structure of the load lock of Figs. 3 and 4 which functions in accordance with the present invention.

As illustrated in Fig. 5, a load lock 10 is provided in a wall 11 of a wafer processing apparatus 12. The wall 11 encloses an internal main processing vacuum chamber 13 which is preferably maintained continuously at an internal vacuum pressure level and which usually contains a gas other than air. In a sputter processing apparatus, for example, where the gas in the internal environment 13 is to be ionized in the course of a coating or etching process, the gas may be typically an inert gas such as argon. An external environment 14, which is usually air at atmospheric pressure, surrounds the apparatus 12 and lies outside of the main chamber wall 11 of the apparatus 12. This external environment will invariably contain at least some moisture.

The load lock 10 encloses an intermediate transfer or load lock chamber 15 between the internal environment 13 and the external environment 14. The load lock 10 has, located on the side thereof toward the external environment 14, a load lock door 16 which, when open, permits passage of the articles to be processed between the load lock chamber 15 and the external environment 14. The door 16 sealably closes to isolate the external environment 14 from the environment within the load lock chamber 15. The load lock 10 is also provided with a closable entry 17 through which wafers or other substrate articles are moved between the load lock chamber 15 and the internal environment 13 of the main chamber where they are processed. The entry 17 is illustrated as sealed in Fig. 5 between a movable chamber section 18 which clamps a wafer holder support and sealing ring 19 against the wall 11 around the chamber door 16.

An article such as a semiconductor wafer 20 is supported in the load lock chamber 15 in a holder 21 carried by the ring 19. The ring 19 is in turn resiliently mounted on a rotatable index plate 22 which is in the main chamber 13. The chamber section 18 is retractable away from the wall 11 so as to open the entry 17 between the load lock chamber 15 and the main chamber 13 to allow the wafer 20 in the holder 21 to be moved edgewise between the load lock chamber 15 and a processing station within the main chamber 13 as the plate 22 rotates.

The load lock 10 is provided with an exhaust port 23 to which is connected a vacuum pump 24 for pumping the load lock chamber 15 to the vacuum pressure level of the internal environment of the main chamber 13. The load lock 10 is also provided with a vent port 25 for venting or refilling the load lock chamber 15 so as to restore the pressure within the load lock chamber to that of the external atmosphere 14.

An unprocessed wafer 20 is introduced from the external atmosphere 14 into the internal environment of the main chamber 13 through the opened load lock door 16 while the entry or passage 17 between the load lock chamber 15 and the main chamber 13 is sealed. A processed wafer 20 is transferred through the open door 16 between the load lock chamber 15 of the load lock 10 and the external environment 14. The transfer of the wafer 20 between the external environment 14 and the load lock chamber 15, including the method and the mechanism for so transferring the wafers, is disclosed in the commonly assigned U.S. Patent No. 4,915,564 .

When the wafer is with the environment 15 of the chamber 10 and the chamber door 16 is closed, sealing the internal environment 15 from the external environment 14, the load lock chamber 15 is pumped to the same pressure level as the internal environment of the main chamber 13. The pump 24 evacuates the load lock chamber 10 through the exhaust port 23. The pumping of the load lock chamber 10 may also be accompanied by the injection of replacement gas through the vent port 25 of the load lock chamber 10 so that the near vacuum pressure level ultimately achieved in the load lock chamber 10 is the same gas composition as that of the internal environment 13.

The pumping of the chamber 15 is accomplished as rapidly as possible in order to maximize the productive use of the machine. The rapid pumping and resulting rapid drop in the pressure within the chamber 15 often results in a momentary condensation of the air borne water vapor carried by the gas from the external environment 14 which initially filled the chamber. This condensation poses a problem to which the present invention is directed, as set forth more fully below.

Once the load lock 10 has been pumped and the environment of the load lock chamber 15 is at the pressure level of the main chamber environment 13, the load lock 10 is opened to the internal environment of the main chamber 13 and the wafers 20 are moved to the main chamber 13, where they step through a plurality of processing stations within the main chamber 13 for processing. A sputter processing apparatus and the method of transferring the wafers 20 from the load lock throughout the main chamber 13 are described in the commonly assigned U.S. Patent No. 4,909,695.

The transfer of wafers from the main chamber 13 to the external environment 14 need not take place through the same load lock as the passage of wafers from the external environment 14 to the main chamber 13. Preferably, however, a single load lock 10 is used for the transfer of wafers in both directions, with processed and unprocessed wafers being exchanged in the load lock. For purposes of describing the present invention, a single load lock is therefore described for both purposes.

For transfer of a wafer 20 from the main chamber 13 to the external environment 14, the load lock 10 is opened to the main chamber 13 so that the wafer 20 moves from the main chamber 13 to the load lock chamber 15 through the entry 17. In the preferred apparatus 12 described in the patents incorporated above, a processed wafer is transferred from the main chamber 13 to the load lock chamber 15 simultaneously with the transfer of an unprocessed wafer from the load lock chamber 15 to the main chamber 13 as the plate 22 rotates, thereby exchanging one wafer 20, ring 19 and holder 21 with another in the load lock chamber 15.

When a processed wafer 20 is positioned in the load lock 10 for transfer to the external environment 14, and the load lock chamber environment 15 is isolated from that of the main chamber 13, vent gas is released through a valve 26 into the chamber 15 to allow the pressure within the chamber 15 to rise to that of the external environment 14. Once the pressures have been equalized in the chamber 15 with respect to the external environment 14, the load lock door 16 is opened and the wafer 20 is removed from the load lock 10.

Referring to Figs. 1-2, solid particulates 27, which have a tendency to collect on various surfaces within the chamber 15 of the load lock 10, are illustrated as they would be found in load lock chambers of the prior art. The wafer 20 in the chamber 15 has a device surface 28 on one side thereof on which are formed a number of semiconductor devices. The particles 27, when allowed to migrate to the device surface 28 of the wafer 20, cause defects in devices formed during processing. This is particularly a problem upon entry of the wafers into the main chamber 13, as illustrated in Fig. 1, but also occurs with respect to wafers being removed from the main chamber 13, as shown in Fig. 2, in that such wafers may go from the load lock chamber 15 and the apparatus 12 to other devices where the particles also interfere with further processing.

As further illustrated in Fig. 2, the environment within the chamber 15 is shown immediately following the rapid pressure drop caused by the pumping of the chamber 15. As this pressure drop occurs, a cloud of moisture droplets, or fog, 27a, which has a tendency to form in the chamber 15 of the load lock 10, is illustrated as it would be found in load lock chambers of the prior art. As with particulates, the fog 27a, when allowed to precipitate onto the device surface 28 of the wafer 20, can cause defects in devices to be formed during processing. The moisture which condenses on the surface 28 carries with it solids or dissolved substances, which, when the moisture ultimately evaporates, remains on the surface 28 as a contaminant, which inhibits the proper processing of the surface 28. This is particularly a problem upon entry of the wafers into the main chamber 13, as illustrated in Fig. 2.

In the prior art, both the venting of the load lock chamber 15 (Fig. 1) and the pumping of the load lock chamber (Fig. 2) cause a turbulent flow of gas within the internal environment 15 of the chamber 10. The turbulent gas flow dislodges particles 27 from the internal surfaces within the load lock 10 and moves dislodged particles through the environment in the load lock chamber 15. Some of the gas borne particles alight upon the device surface 28 of the wafer 20, each of which is capable of damaging one of the semiconductor devices. Where the wafer 20 is an 20.3 cm (8˝) diameter circular wafer being formed into a large number of semiconductor devices, for example, approximately 40 to 50 defective devices may result from the particles which alight on the device surface 28.

Also, in the prior art, whether by venting of the load lock chamber 15 or by the pumping of the load lock chamber, a rapid pressure drop can cause a condensation of vapor within the internal environment 15 of the chamber 10. The condensation produces a fog 27a in the internal volume of the chamber 15 within the load lock 10. The gas borne water droplets alight upon the device surface 28 of the wafer 20, and are capable of damaging the semiconductor devices to be formed thereon.

Referring to Figs. 3-5, according to the principles of the present invention, the load lock chamber 10 is provided with a guide or plate 30 which is closely spaced adjacent, and substantially parallel, to the device surface 28 of the wafer 20 so as to form a gap 31 therebetween which covers the device surface 28 of the wafer 20. The plate 30 is preferably circular and at least as large as the device surface 28 of the wafer 20. Since plate 30 is generally planar and parallel to the wafer device surface 28, the gap formed therewith is of uniform thickness. This gap thickness is preferably in the range from 1.3 to 13 mm (0.05 to 0.50 inches), with a spacing of approximately 2.5 mm (0.1 inches) preferred. The plate 30 may also be a surface of another structure similarly Positioned such as a front-plane heater, where one is provided. With the preferred embodiment of the present invention, however, a vent line 33 is connected between the vent inlet port 25 and an orifice 35 in the guide plate 30 over the device surface 28. Preferably, the orifice 35 is centrally located on the plate 30, to communicate some or all of the vent gas from the inlet 25 to the gap 31, during both the venting (Fig. 3) and the pumping (Fig. 4) of the load lock chamber 10 to the desired vacuum.

According to the preferred embodiment of the invention, a vent gas, such as dry nitrogen or argon, is introduced into the lock lock chamber 15 at a pressure of 6.9 kN/m² to 21 kN/m² (1 to 3 psi) more than that of the load lock chamber 15 through the duct 33 and centrally into, and radially outwardly from, the gap 31 during the filling process of Fig. 3 for example by venting, to bring the load lock to atmospheric pressure in about 10 seconds. In evacuating the load lock, as for example by pumping, the flow will usually be at such a rate as to initially bring the load lock chamber 15 from atmospheric pressure to a significant vacuum level also in about ten seconds. Since the load lock chamber is about 1.5 liters in volume, the average initial flow rate for pumping the chamber is about 9 liters per minute. The introduced vent gas is preferably ultra dry, typically of less than ten parts per million moisture content. At such a level, no moisture will condense from the vent gas, which is the only gas that will be in contact with the surface of the wafer to be protected.

At all times that gases are flowing to or from the load lock chamber 10, a flow of clean vent gas is maintained in a direction radially outwardly away from the gap 31 around the full perimeter of the device surface 28 of the wafer 20. This is shown by the arrows 37. This outward flow of gas is maintained in an outward direction around the perimeter of the device surface 28 by maintaining the pressure of the clean dry gas at the orifice 35 sufficiently in excess of the pressure in the chamber 15 around the edge of the gap 31. In this manner, particulates 27 that are picked up from the internal surfaces of the load lock chamber 15, and droplets 27a that are formed in the load lock chamber 15, are still carried by the moving gas, but are instead deflected or otherwise prevented from contacting the device surface 28 or entering the gap 31 by the radially outwardly flow of clean vent gas as shown by arrows 37. The vent gas entering the inlet port of vent 25 may be typically, for example, nitrogen gas from a source 40 which is passed through a filter 41, preferably a 0.02 micrometer filter to remove particulates therefrom, then through the valve 26 which is a clean valve, preferably a bellows type, which controls the flow of the gas from the source 40 into an electropolished no bend gas line 45 which communicates with the inlet port 25 to the load lock chamber 10.

## Claims

1. A method of protecting a substrate supported in a pressure sealed chamber of a processing apparatus from contamination borne by a gas during a change of gas pressure within the chamber comprising covering the substrate, the cover having an orifice therein, changing the pressure of the contaminant carrying gas within the chamber by flowing gas through a port in the wall of the chamber, and introducing a clean gas through the orifice during the changing of the gas pressure, characterised in that at least one particular surface of the substrate is protected, which surface is to be subjected to processing in that a gap is formed covering the surface to be protected which is adjacent and parallel to the surface and has a boundary encircling the surface and the gap orifice and communicating with the chamber and in that the method includes guiding the introduced clean gas along the gap across the surface to be protected and outwardly from the gap along the boundary thereof and into the chamber during the changing of the pressure of the contaminant carrying gas within the chamber to limit the flow of gas borne contaminants from the chamber, into the gap and onto the surface to be protected.

2. A method as claimed in Claim 1, wherein the pressure is changed by increasing the pressure of the gas within the chamber by flowing gas through the port into the chamber, at least some of which is the clean gas introduced through the orifice.

3. A method as claimed in Claim 1, wherein the pressure is changed by removing gas from the chamber through the port at a location remote from the gap at a predetermined flow rate until the chamber has reached a predetermined lower pressure level and wherein the clean gas is introduced into the gap, while removing gas therefrom, at a flow rate less than the predetermined flow rate.

4. A method as claimed in Claim 3, wherein the gas is removed by pumping gas from the chamber at a predetermined flow rate and until the chamber has reached a vacuum pressure level.

5. A method as claimed in either Claim 3 or Claim 4, wherein the clean gas introduced is a clean dry gas, the clean dry gas being introduced into the gap through the orifice in the guide plate at a pressure sufficient to maintain a flow of the gas outwardly from the gap around the periphery thereof and into the chamber during the evacuation of gas from the chamber so as to limit the flow of gas borne moisture from the chamber, into the gap and onto the surface to be protected to thereby protect the surface from contamination by moisture.

6. A method as claimed in any one of Claims 3 to 5, wherein the chamber is operated in a cycle which includes filling the chamber subsequent to the removing of gas therefrom at least partially by introducing the clean gas into the gap, and guiding the introduced clean gas, during filling, along the surface to be protected and through the gap so as to flow outwardly at the boundary of the gap into the chamber.

7. A method as claimed in any preceding Claim, further comprising alternately venting the chamber to the pressure of an external environment and pumping the chamber to the pressure of an internal environment; gas introduction being performed during venting and pumping.

8. A method as claimed in any preceding Claim, wherein the clean gas is introduced at a pressure sufficient to produce a pressure around the boundary of the gap that exceeds the pressure of the chamber, thereby maintaining the flow of clean gas outwardly from the gap boundary.

9. A method as claimed in any preceding Claim, wherein the gap is formed with a guide plate positioned adjacent to and spaced from the surface to be protected and the clean gas is introduced into the gap by way of a centrally disposed opening in the plate to establish the gas flow in the gap radially outwardly in all directions.

10. A method as claimed in any preceding Claim, wherein the surface is protected from particulate contamination during turbulent flow of gas in the chamber during the pumping or venting of the chamber and wherein the clean gas is introduced whenever sufficient gas is flowing in the chamber to dislodge and carry particles from the walls of the chamber.

11. A processing apparatus in which substrates are processed in an internal environment isolated from an external environment comprising a chamber sealable from the external environment and having a substrate holder for supporting a substrate in the chamber, a gas inlet port and a gas outlet port, one of the ports being a vent port for venting the chamber to the pressure of the external environment, and the other of the ports being a pump port for pumping the chamber to the pressure of the internal environment, means for changing the pressure within the chamber between that of the internal and that of the external environments, a cover for the substrate with an orifice therein and means for supplying a gas at the orifice that is relatively clean of contaminants from which the substrate is to be protected, characterised in that in use at least one particular surface (28) of the substrate (20) is protected from contamination, which surface is to be subjected to processing, and in that the apparatus includes a guide (30) having the orifice (35) therein and positioned to lie adjacent and parallel to and closely spaced from the surface (28) to be protected to form a gap (31) covering the surface (28) to be protected with the periphery of the gap (31) surrounding the orifice (35) and the surface (28) to be protected and means (26) for introducing the clean gas from the gas supplying means (40) into the gap (31) through the orifice (35) in the guide at a pressure that is sufficient to produce pressure around the periphery of the gap (31) that exceeds the pressure of the chamber (15) and decreases from the orifice (35) to the periphery of the gap (31) and is sufficient to maintain a flow of the clean gas outwardly from the gap (31) at the periphery thereof and into the chamber (15) when a substrate (20) is supported in the chamber (15) and pressure is changing therein, so as to thereby limit the flow of gas borne contamination from the chamber (15), into the gap (31) and onto the surface (28) to be protected.

12. A processing apparatus as claimed in Claim 11, wherein the pressure changing means includes means (24) connected to the outlet port (23) for pumping gas from the chamber (13) and thereby reducing the pressure therein and the means for introducing clean gas includes a supply of clean dry gas (40) and means for introducing the clean dry gas from the supply (40) into the gap (31) through the orifice (35) in the guide plate (30) so as to thereby limit condensation which may form in the chamber (13) from entering the gap (31) and contacting the surface (28) to be protected.

13. Apparatus as claimed in either Claim 11 or Claim 12, wherein the chamber is a load lock chamber (15), including a wall enclosing the chamber (15) and having a door (16) therein for alternately opening the chamber (15) to, and sealing the chamber from, the external environment (14) and for passage of substrates (20) into and out of the chamber (15) when the chamber is open to the external environment (14) and a sealable entry (17) therein for alternately opening the chamber (15) to, and sealing the chamber (15) from, the internal environment (13) and for the passage of substrates (20) into and out of the chamber (15) when the chamber (15) is open to the internal environment (13) and wherein the gas inlet and gas outlet ports (23, 25) communicate with the load lock chamber (15) whereby the means for preventing contamination of the substrate (20) by gas borne contaminants is operable to prevent contamination during the evacuation or filling of the load lock chamber (15).

## Patentansprüche

1. Ein Verfahren zum Schutz eines in einer druckdichten Kammer eines Verfahrensgeräts abgestützten Substrats gegen durch ein Gas während einer Gasdruckänderung innerhalb der Kammer mitgeführte Verunreinigung, umfassend die Stufen der Abdeckung des Substrats, wobei sich in dem Abdeckmittel eine Öffnung befindet, der Veränderung des Druckes des die Verunreinigung mitführenden Gases innerhalb der Kammer durch Hindurchleiten von Gas durch eine Öffnung in der Wand der Kammer und der Einführung eines reinen Gases durch die Öffnung während der Gasdruckänderung, dadurch gekennzeichnet, daß mindestens eine bestimmte Oberfläche des Substrats geschützt ist, und zwar die dem Verfahren zu unterziehende Oberfläche, daß ein Spalt gebildet wird, der sich über die zu schützende Oberfläche erstreckt, wobei der besagte Spalt an die Oberfläche angrenzt, zu dieser parallel ist und eine die Oberfläche und die Spaltöffnung umgebende und mit der Kammer in Kommunikation befindliche Abgrenzung hat, sowie dadurch, daß das Verfahren die Stufen des Leitens des eingeführten reinen Gases entlang dem Spalt und über die zu schützende Oberfläche hinweg und von dem Spalt nach außen entlang dessen Abgrenzung und in die Kammer einschließt, während der Druck des die Verunreinigung mitführenden Gases innerhalb der Kammer geändert wird, um den Fluß von durch Gas mitgeführten Verunreinigungen aus der Kammer in den Spalt und auf die zu schützende Oberfläche zu begrenzen.

2. Ein Verfahren nach Anspruch 1, bei dem der Druck durch Erhöhen des Gasdruckes innerhalb der Kammer geändert wird, indem man Gas durch die Öffnung in die Kammer leitet, wobei das besagte Gas mindestens zum Teil das durch die Öffnung eingeführte reine Gas ist.

3. Ein Verfahren nach Anspruch 1, bei dem der Druck geändert wird, indem man an einem von dem Spalt entfernten Punkt Gas durch die Öffnung hindurch aus der Kammer entfernt, und zwar bei einer vorbestimmten Fließgeschwindigkeit, bis in der Kammer ein vorbestimmter niedrigerer Druckpegel erreicht ist, und bei dem das reine Gas während des Entfernens von Gas aus dem Spalt in den besagten Spalt eingeführt wird, und zwar mit einer Fließgeschwindigkeit, die geringer ist als die vorbestimmte Fließgeschwindigkeit.

4. Ein Verfahren nach Anspruch 3, bei dem das Gas durch Pumpen des Gases bei einer vorbestimmten Fließgeschwindigkeit aus der Kammer entfernt wird, bis in der Kammer ein Vakuumpegel hergestellt ist.

5. Ein Verfahren nach Anspruch 3 oder Anspruch 4, bei dem das eingeführte reine Gas ein reines trockenes Gas ist, wobei das reine trockene Gas durch die Öffnung in der Leitplatte in den Spalt eingeführt wird und zwar bei einem Druck, der ausreicht, um einen von dem Spalt rings um dessen Außenrand auswärts gerichteten und während der Evakuierung von Gas aus der Kammer in die Kammer führenden Gasfluß aufrechtzuerhalten, um den Fluß von durch Gas mitgeführter Feuchtigkeit aus der Kammer in den Spalt und auf die zu schützende Oberfläche zu begrenzen, um dadurch die Oberfläche gegen Verunreinigung durch Feuchtigkeit zu schützen.

6. Ein Verfahren nach einem der Ansprüche 3 bis 5, bei dem die Kammer in einem Kreislauf betrieben wird, der mindestens teilweises Füllen der Kammer nach dem Entfernen von Gas daraus durch Einführen des reinen Gases in den Spalt und Leiten des eingeführten reinen Gases während des Füllens entlang der zu schützenden Oberfläche und durch den Spalt hindurch einschließt, so daß es an der Abgrenzung des Spaltes auswärts in die Kammer fließt.

7. Ein Verfahren nach einem der vorstehenden Ansprüche, des weiteren umfassend wechselweise Entgasung der Kammer auf den Druck einer externen Umgebung und Pumpen der Kammer auf den Druck einer internen Umgebung, wobei die Einführung von Gas während des Entgasens und Pumpens stattfindet.

8. Ein Verfahren nach einem der vorstehenden Ansprüche, bei dem das reine Gas unter einem Druck eingeführt wird, der ausreicht, um rings um die Abgrenzung des Spaltes einen Druck zu erzeugen, der den Kammerdruck übersteigt, so daß der Fluß reinen Gases von der Spaltabgrenzung auswärts aufrechterhalten wird.

9. Ein Verfahren nach einem der vorstehenden Ansprüche, bei dem der Spalt mit einer anschließend an und in Abstand von der zu schützenden Oberfläche angeordneten Leitplatte gebildet wird und das reine Gas in den Spalt durch eine in der Mitte der Platte angeordnete Öffnung eingeführt wird, um den Gasfluß in dem Spalt radial auswärts in allen Richtungen herzustellen.

10. Ein Verfahren nach einem der vorstehenden Ansprüche, bei dem die Oberfläche bei turbulentem Gasfluß in der Kammer während des Pumpens bzw. Entgasens der Kammer gegen Verunreinigung durch Teilchen geschützt ist, und bei dem das reine Gas eingeführt wird, wenn immer genügend Gas in der Kammer fließt, um Teilchen von den Wänden der Kammer zu lösen und mitzuführen.

11. Ein Verfahrensgerät, in dem Substrate in einer internen Umgebung, die von einer externen Umgebung getrennt ist, einem Verfahren unterzogen werden, umfassend eine Kammer, die gegen die externe Umgebung abgedichtet werden kann und einen Substrathalter zum Abstützen eines Substrats in der Kammer, eine Gaseinlaßöffnung und eine Gasauslaßöffnung enthält, wobei eine der Öffnungen eine Ablaßöffnung zum Entgasen der Kammer auf den Druck der externen Umgebung und die andere Öffnung eine Pumpöffnung zum Pumpen der Kammer auf den Druck der internen Umgebung ist, sowie Mittel zum Ändern des Druckes innerhalb der Kammer zwischen dem der internen Umgebung und dem der externen Umgebung, eine Abdeckung für das Substrat mit einer darin vorgesehenen Öffnung und Mittel zum Einspeisen eines Gases an der Öffnung, das von Verunreinigungen, gegen die das Substrat zu schützen ist, relativ frei ist, dadurch gekennzeichnet, daß im Betrieb mindestens eine bestimmte Oberfläche (28) des Substrats (20), die einem Verfahren unterzogen werden soll, gegen Verunreinigung geschützt ist, und daß das Gerät eine Leitvorrichtung (30) umfaßt, in der sich die Öffnung (35) befindet, wobei die besagte Leitvorrichtung so angeordnet ist, daß sie anschließend an, parallel zu und in geringem Abstand von der zu schützenden Oberfläche (28) angeordnet ist, um einen sich über die zu schützende Oberfläche (28) erstreckenden Spalt (31) zu bilden, wobei der Außenrand des Spaltes (31) die Öffnung (35) und die zu schützende Oberfläche (28) umgibt, sowie Mittel (26) zum Einführen des reinen Gases von dem Gaszufuhrmittel (40) durch die Öffnung (35) in der Leitvorrichtung in den Spalt (31), und zwar bei einem Druck, der ausreicht, um rings um den Außenrand des Spaltes (31) einen Druck zu erzeugen, der den Druck in der Kammer (15) übersteigt und von der Öffnung (35) bis zu dem Außenrand des Spaltes (31) abnimmt und ausreicht, um einen Fluß des reinen Gases von dem Spalt (31) an dessen Außenrand in Auswärtsrichtung und in die Kammer (15) aufrechtzuerhalten, wenn in der Kammer (15) ein Substrat (20) abgestüzt ist und sich der Druck in der besagten Kammer ändert, um dadurch den Fluß von durch Gas mitgeführter Verunreinigung aus der Kammer (15) in den Spalt (31) und auf die zu schützende Oberfläche (28) zu begrenzen.

12. Ein Verfahrensgerät nach Anspruch 11, bei dem das Mittel zum Ändern des Druckes ein an der Auslaßöffnung (23) angeschlossene Mittel (24) zum Pumpen von Gas aus der Kammer (13) umfaßt, um dadurch den darin vorherrschenden Druck zu reduzieren, und das Mittel zum Einführen von reinem Gas eine Versorgung von reinem trockenem Gas (40) und Mittel zum Einführen des reinen trockenen Gases von der Versorgung (40) in den Spalt (31) durch die in der Leitplatte (30) befindliche Öffnung (35) umfaßt, um dadurch das Eindringen von möglicherweise in der Kammer (13) gebildeter Kondensation in den Spalt (31) und Kontakt der besagten Kondensation mit der zu schützenden Oberfläche (28) einzuschränken.

13. Gerät nach Anspruch 11 oder Anspruch 12, bei dem die Kammer eine Werkstücktransferkammer (15) mit einer die Kammer (15) umschließenden Wand ist, wobei sich in der besagten Wand eine Tür (16) befindet, um die Kammer (15) wechselweise im Verhältnis zu der externen Umgebung (14) zu öffnen bzw. abzudichten und zwecks Durchgang von Substraten (20) in die Kammer (15) hinein und aus ihr heraus, wenn die Kammer im Verhältnis zu der externen Umgebung (14) offen ist, während in dem Gerät ein abdichtbarer Eingang (17) vorgesehen ist, der zu wechselweisem Öffnen der Kammer (15) und Abdichten der Kammer (15) im Verhältnis zu der internen Umgebung (13) und als Durchgang für Substrate (20) in die Kammer (15) und aus dieser heraus dient, wenn die Kammer (15) im Verhältnis zu der internen Umgebung (13) offen ist, und in dem die Gaseinlaß- und Gasauslaßöffnungen (23, 25) mit der Werkstücktransferkammer (15) in Kommunikation sind, wobei das Mittel zum Verhüten vom Verunreinigung des Substrats (20) durch von durch Gas mitgeführte verunreinigende Stoffe so betrieben werden kann, daß Verunreinigung während des Evakuierens bzw. Füllens der Werkstücktransferkammer (15) verhindert wird.

## Revendications

1. Procédé de protection d'un subjectile supporté dans une chambre de pression étanche d'un appareil de traitement contre la contamination transportée par un gaz au cours d'un changement de pression de gaz à l'intérieur de la chambre, comprenant le recouvrement du subjectile, le couvercle comportant un orifice, le changement de la pression du gaz transportant le contaminant dans la chambre en faisant circuler le gaz par un orifice dans la paroi de la chambre, et l'introduction d'un gaz propre par l'orifice pendant le changement de pression de gaz, caractérisé en ce qu'au moins une surface particulière du subjectile est protégée, cette surface devant être soumise au traitement, en ce qu'un espace est formé et couvre la surface à protéger, qui est adjacent et parallèle à la surface et a une limite encerclant la surface et l'orifice de l'espace et communiquant avec la chambre, et en ce que le procédé comprend le guidage du gaz propre introduit le long de l'espace en travers de la surface à protéger et vers l'extérieur depuis l'espace le long de la limite de celui-ci et dans la chambre pendant le changement de pression du gaz transportant le contaminant à l'intérieur de la chambre pour limiter l'écoulement des contaminants transportés par le gaz de la chambre, dans l'espace et sur la surface à protéger.

2. Procédé selon Revendication 1 dans lequel la pression est changée par augmentation de la pression du gaz à l'intérieur de la chambre en faisant pénétrer un gaz par l'orifice dans la chambre, au moins une partie du gaz étant le gaz propre introduit par l'orifice.

3. Procédé selon Revendication 1, dans lequel la pression est changée par enlèvement de gaz de la chambre par l'orifice à un emplacement éloigné de l'espace à un débit prédéterminé jusqu'à ce que la chambre ait atteint un niveau de pression inférieur prédéterminé et dans lequel le gaz propre est introduit dans l'espace, pendant l'enlèvement du gaz de celui-ci, à un débit inférieur au débit prédéterminé.

4. Procédé selon Revendication 3, dans lequel le gaz est enlevé par extraction de gaz de la chambre par pompage à un débit prédéterminé et jusqu'à ce que la chambre ait atteint une dépression.

5. Procédé selon revendication 3 ou Revendication 4, dans lequel le gaz propre introduit est un gaz sec propre, le gaz sec propre étant introduit dans l'espace par l'orifice dans la plaque de guidage à une pression suffisante pour maintenir une circulation du gaz vers l'extérieur par rapport à l'espace autour de la périphérie de celui-ci et dans la chambre au cours de l'évacuation du gaz de la chambre de manière à limiter la circulation de l'humidité transportée par le gaz sortant de la chambre, entrant dans l'espace et passant sur la surface à protéger, de manière à protéger ainsi la surface de la contamination par l'humidité.

6. Procédé selon l'une quelconque des Revendications 3 à 5, dans lequel la chambre est exploitée dans un cycle qui comprend le remplissage de la chambre après enlèvement du gaz de celle-ci au moins partiellement en introduisant du gaz propre, pendant le remplissage, le long de la surface à protéger et à travers l'espace de telle manière qu'il circule vers l'extérieur à la limite de l'espace entrant dans la chambre.

7. Procédé selon l'une quelconque des Revendications précédentes, comprenant en outre la mise en communication de la chambre avec la pression d'un milieu extérieur et le pompage de la chambre à la pression d'un milieu intérieur; l'introduction de gaz étant effectuée pendant la mise en communication et le pompage.

8. Procédé selon l'une quelconque des Revendications précédentes, dans lequel le gaz propre est introduit à une pression suffisante pour produire une pression autour de la limite de l'espace qui dépasse la pression de la chambre, en maintenant ainsi la circulation d'air propre vers l'extérieur par rapport à la limite de l'espace.

9. Procédé selon l'une quelconque des Revendications précédentes, dans lequel l'espace est formé avec une plaque de guidage positionnée à proximité de la surface à protéger et à une certaine distance de celle-ci et où le gaz propre est introduit dans l'espace par l'intermédiaire d'une ouverture disposée centralement dans la plaque pour établir l'écoulement radial de gaz dans l'espace vers l'extérieur dans toutes les directions.

10. Procédé selon l'une quelconque des revendications précédentes, dans lequel la surface est protégée de la contamination par les particules pendant la circulation turbulente du gaz dans la chambre pendant le pompage ou la mise en communication de la chambre et dans lequel le gaz propre est introduit chaque fois qu'il y a une circulation suffisante de gaz dans la chambre pour déloger et entraîner les particules se trouvant sur les parois de la chambre.

11. Procédé de traitement dans lequel les subjectiles sont traités dans un milieu intérieur isolé d'un milieu extérieur, comprenant une chambre pouvant être séparée hermétiquement du milieu extérieur et ayant un support de subjectile pour supporter un subjectile dans la chambre, un orifice d'entrée de gaz et un orifice de sortie de gaz, un des orifices étant un orifice d'évent pour faire communiquer la chambre avec la pression du milieu extérieur, et l'autre orifice étant un orifice de pompage pour pomper la chambre à la pression du milieu intérieur, un moyen pour changer la pression à l'intérieur de la chambre entre celle du milieu intérieur et celle du milieu extérieur, un couvercle pour le subjectile, avec un orifice dans ledit couvercle, et un moyen pour fournir à l'orifice un gaz qui est relativement exempt des contaminants dont le subjectile doit être protégé, caractérisé en ce qu'en utilisation, au moins une surface particulière (28) du subjectile (20) est protégée de la contamination, ladite surface doit être soumise au traitement, et en ce que l'appareil comprend un guide (30) comportant l'orifice (35) et positionné de manière à se trouver à proximité de la surface (28) à protéger, parallèlement à celle-ci et étroitement espacé par rapport à elle pour former un espace (31) couvrant la surface (28) à protéger avec la périphérie de l'espace (31) entourant l'orifice (35) et la surface (28) à protéger, et un moyen (26) pour introduire le gaz propre provenant du moyen de fourniture du gaz (40) dans l'espace (31) par l'orifice (35) dans le guide à une pression qui est suffisante pour produire autour de la périphérie de l'espace (31) une pression qui dépasse la pression de la chambre (15) et diminue de l'orifice (35) à la périphérie de l'espace (31) et est suffisante pour maintenir un débit du gaz propre vers l'extérieur depuis l'espace (31) à la périphérie de celui-ci et dans la chambre (15) lorsqu'un subjectile (20) est supporté dan la chambre (15) et que la pression change dans celle-ci, de manière à limiter ainsi l'écoulement de la contamination transportée dans le gaz de la chambre (15), dans l'espace (31) et sur la surface (28) à protéger.

12. Appareil de traitement selon Revendication 11, dans lequel le changement de pression comprend un moyen (24) relié à l'orifice de sortie (23) pour pomper le gaz venant de la chambre (13) et réduire ainsi la pression à l'intérieure de celle-ci et dans lequel le moyen pour introduire du gaz propre comprend une alimentation de gaz propre et sec (40) et un moyen pour introduire le gaz propre et sec de l'alimentation (40) dans l'espace (31) par l'orifice (35) dans la plaque de guidage (30) de manière à empêcher ainsi en partie la condensation qui peut se former dans la chambre (13) d'entrer dans l'espace (31) et d'entrer en contact avec la surface (28) à protéger.

13. Appareil selon Revendication 11 ou Revendication 12, dans lequel la chambre est un sas de chargement (15), comportant une paroi enfermant le sas (15) et comportant une porte (16) pour permettre alternativement d'ouvrir le sas (15) au milieu extérieur (14) et de l'en isoler, et pour permettre l'entrée des subjectiles (20) dans le sas et leur sortie lorsque le sas est ouvert au milieu extérieur (14) et une entrée (17) pouvant être fermée hermétiquement pour permettre alternativement d'ouvrir le sas (15) au milieu intérieur (13) et de l'en isoler et pour permettre l'entrée des subjectiles (20) dans le sas (15) et leur sortie lorsque le sas (15) est ouvert au milieu intérieur (13), et dans lequel les orifices d'entrée de gaz et de sortie de gaz (23,25) communiquent avec le sas de chargement (15), ce qui permet le fonctionnement du moyen pour empêcher la contamination du subjectile (20) par les contaminants transportés par le gaz afin d'empêcher la contamination pendant l'évacuation ou le remplissage du sas de chargement (15).
